# EUROPÄISCHE PATENTSCHRIFT

(11) **EP 1 097 460 B1**
(45) Veröffentlichungstag und Bekanntmachung des Hinweises auf die Patenterteilung: **05.06.2002**
(21) Anmeldenummer: 99945908.4
(22) Anmeldetag: 05.07.1999
(51) Int. Cl.: G11C 29/00

(54) **INTEGRIERTE SCHALTUNG MIT EINER SELBSTTESTEINRICHTUNG ZUR DURCHFÜHRUNG EINES SELBSTTESTS DER INTEGRIERTEN SCHALTUNG**
INTEGRATED CIRCUIT COMPRISING A SELF-TEST DEVICE FOR EXECUTING A SELF-TEST OF THE INTEGRATED CIRCUIT
CIRCUIT INTEGRE COMPORTANT POUR SON AUTOCONTROLE UN DISPOSITIF D'AUTOVERIFICATION

(30) Priorität: 23.07.1998 DE 19833208
(43) Veröffentlichungstag der Anmeldung: 09.05.2001
(73) Patentinhaber: Infineon Technologies AG, 81669 München (DE)
(72) Erfinder: KAISER, Robert, D-86916 Kaufering (DE); SCHAMBERGER, Florian, D-83435 Bad Reichenhall (DE)
(74) Vertreter: Müller - Hoffmann & Partner
(86) Internationale Anmeldenummer: DE9902069
(87) Internationale Veröffentlichungsnummer: WO0005723

(56) Entgegenhaltungen:
- EP-A- 0 018 736
- US-A- 4 482 953
- US-A- 4 607 366

## Beschreibung

Die Erfindung betrifft eine integrierte Schaltung mit einer Selbsttesteinrichtung zur Durchführung eines Selbsttests der integrierten Schaltung.

Eine derartige integrierte Schaltung ist beispielsweise in der US-A 5,173,906 beschrieben. Die Selbsttesteinrichtung (Built-In Self-Test) unterzieht bestimmte Schaltungseinheiten der integrierten Schaltung einer Überprüfung, wobei nach Abschluß dieser Überprüfung ein Ergebnissignal nach außerhalb der integrierten Schaltung übermittelt wird.

Selbsttesteinrichtungen können entweder als verdrahtete Logik oder durch einen Controller oder Prozessor realisiert sein, der ein entsprechendes Testprogramm abarbeitet. Im letztgenannten Fall ist es möglich, der Selbsttesteinrichtung von außen verschiedene Testprogramme nacheinander zuzuführen, die jeweils die Ausführung unterschiedlicher Tests ermöglichen. Insbesondere, wenn gleichzeitig eine große Anzahl von integrierten Schaltungen einem Selbsttest unterzogen werden soll, kann dieses Vorgehen problematisch sein. Auch bei integrierten Schaltungen gleicher Art kann es nämlich je nach Verlauf des Tests zu unterschiedlichen Programmlaufzeiten für die nacheinander durchzuführenden Testprogramme kommen. Wenn die Zuführung der einzelnen Testprogramme durch eine zentrale externe Steuereinheit vorgenommen wird und das Laden der jeweils nachfolgenden Testprogramme in die einzelnen integrierten Schaltungen durch die Steuereinheit jeweils gleichzeitig erfolgen soll, ist es notwendig, vorher die Beendigung des vorhergehenden Testprogrammes in allen betroffenen integrierten Schaltungen abzuwarten. Das bedeutet, daß mit der Ausführung des jeweils nächsten Testprogrammes erst begonnen werden kann, wenn sämtliche integrierte Schaltungen zuvor das vorhergehende Testprogramm abgeschlossen haben. Dieses Vorgehen, das sich jeweils an der längstmöglichen Programmausführdauer orientiert, führt zu einem hohen Zeitaufwand für die Ausführung sämtlicher Testprogramme.

Der Erfindung liegt die Aufgabe zugrunde, eine integrierte Schaltung mit einer Selbsttesteinrichtung anzugeben, für die der Selbsttest einer großen Anzahl dieser Schaltungen mit geringerem Zeitaufwand möglich ist.

Diese Aufgabe wird mit einer integrierten Schaltung gemäß Anspruch 1 gelöst. Vorteilhafte Aus- und Weiterbildungen der Erfindung sind Gegenstand abhängiger Ansprüche.

Die integrierte Schaltung weist eine Selbsttesteinrichtung auf zur Durchführung eines Selbsttests der integrierten Schaltung, die einen Steuerausgang hat. Weiterhin weist die integrierte Schaltung einen mit der Selbsttesteinrichtung verbundenen Programmspeicher zum Speichern wenigstens eines von außerhalb der integrierten Schaltung zugeführten Testprogrammes auf, das während der Durchführung eines Selbsttest durch die Selbsttesteinrichtung ausgeführt wird. Dabei steuert die Selbsttesteinrichtung das Laden des jeweils auszuführenden Testprogrammes von außerhalb der integrierten Schaltung in den Programmspeicher über ihren Steuerausgang.

Bei der Erfindung erfolgt das Laden der Testprogramm in den Programmspeicher der integrierten Schaltung also nicht gesteuert durch eine externe Steuereinheit, sondern selbsttätig durch die auf dem Chip befindliche Selbsttesteinrichtung. Dies hat den Vorteil, daß keine externe Steuereinheit zum Steuern der Zuführung der Testprogramme benötigt wird. Es ist lediglich ein externer Programmspeicher notwendig, von dem die Selbsttesteinrichtung über ihren Steuerausgang das jeweils benötigte Testprogramm abrufen kann. Die Ausführung mehrerer hintereinander auszuführender und nacheinander in den Programmspeicher zu ladender Testprogramme erfolgt bei der erfindungsgemäßen integrierten Schaltung zeitoptimiert, da die Steuerung durch die den Selbsttest selbst durchführende Selbsttesteinrichtung erfolgt.

Die integrierte Schaltung kann eine beliebige integrierte Schaltung sein, wie beispielsweise eine Speicherschaltung oder eine Logikschaltung. Die Art der Selbsttests unterscheidet sich dabei nicht von bekannten Selbsttests. Die Erfindung unterscheidet sich von diesen hinsichtlich der Steuerung des Ladens der Testprogramme in den Programmspeicher der integrierten Schaltung.

Nach einer Weiterbildung der Erfindung führt die Selbsttesteinrichtung nacheinander mehrere Testprogramme aus und lädt durch Steuerung über ihren Steuerausgang das jeweils nächste Testprogramm nach Beendigung des vorhergehenden Testprogramms selbsttätig von außerhalb der integrierten Schaltung in den Programmspeicher.

Dies hat den Vorteil, daß die Selbsttesteinrichtung dem Programmspeicher die Testprogramme bedarfsgerecht zuführt, nämlich direkt nach Beendigung des zuvor ausgeführten Testprogramms. Hierdurch kommt es zu keinem Zeitverlust zwischen der Ausführung der unterschiedlichen Testprogramme, unabhängig davon, wie lange die Selbsttesteinrichtung für die Durchführung des jeweiligen Tests benötigt hat. Diese Zeitdauer ist abhängig vom Verlauf des jeweiligen Tests, so daß die erfindungsgemäße integrierte Schaltung flexibel auf unterschiedliche Programmlaufzeiten reagieren kann und zwischen der Ausführung aufeinanderfolgender Testprogramme keine Totzeiten entstehen.

Die Erfindung ist insbesondere vorteilhaft, wenn, wie eingangs beschrieben, eine große Anzahl gleichartiger integrierter Schaltungen gleichzeitig einen Selbsttest durchführen soll. Da jede integrierte Schaltung die Zuführung des jeweils nächsten Testprogrammes selbsttätig steuert, sind die integrierten Schaltungen hinsichtlich des Beginns der Abarbeitung des jeweils folgenden Testprogrammes unabhängig voneinander. Auch wenn alle integrierten Schaltungen dieselben Testprogramme nacheinander abarbeiten, kann es, wie bereits erwähnt, zu unterschiedlichen Programmlaufzeiten in den verschiedenen Schaltungen kommen. Dies liegt am Verlauf des Tests und ist beispielsweise abhängig davon, ob während der Abarbeitung eines Testprogrammes bereits frühzeitig ein Fehler erkannt wird. Im genannten Fall kann ein Testprogramm möglicherweise frühzeitig beendet werden. Bei einer großen Anzahl nacheinander durchzuführender Testprogramme wird u.U. jedesmal eine andere der gleichzeitig zu testenden integrierten Schaltungen zur Ausführung des jeweiligen Programmes die meiste Zeit benötigen. Daher kommt es insgesamt zu einer Vereinheitlichung der Gesamttestdauer für alle gleichzeitig zu testenden integrierten Schaltungen. Somit kann durch die Erfindung die Gesamttestdauer für alle integrierten Schaltungen minimiert werden.

Die Erfindung wird im folgenden anhand der Figuren näher erläutert.
- Figur 1: zeigt ein erstes Ausführungsbeispiel der Erfindung, und
- Figur 2: zeigt ein Detail eines zweiten Ausführungsbeispiels der Erfindung.

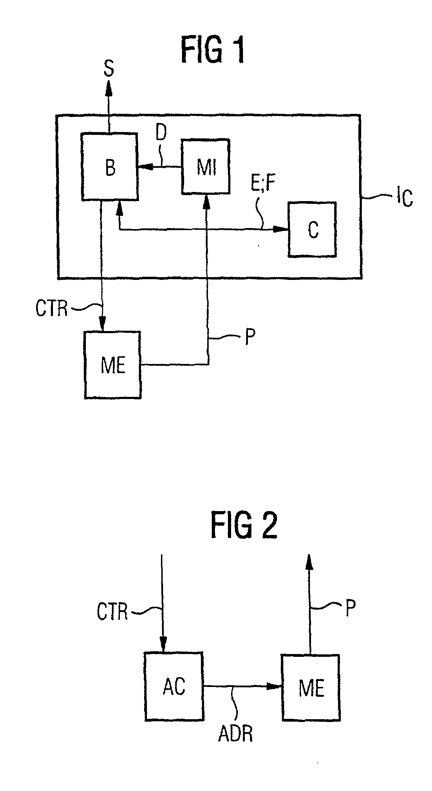

Figur 1 ist eine integrierte Schaltung IC mit einer Selbsttesteinrichtung B, einem internen Programmspeicher MI und einer zu prüfenden Schaltungseinheit C zu entnehmen. Bei der Selbsttesteinrichtung B handelt es sich um einen Controller oder Prozessor zur Durchführung eines Selbsttests der Schaltungseinheit C (Built-In Self-Test). Die Selbsttesteinrichtung B testet die Schaltungseinheit C gemäß eines im internen Programmspeicher MI abgelegten Testprogrammes P. Hierzu werden Programmbefehle D des Testprogramms P vom internen Programmspeicher MI zur Selbsttesteinrichtung B übertragen. Anschließend überträgt die Selbsttesteinrichtung B entsprechende Testsignale E zur Schaltungseinheit C und empfängt von dieser als Antwort entsprechende Antwortsignale F. Diese Antwortsignale F werden in der Selbsttesteinrichtung B mit erwarteten Sollwerten verglichen. Nach Abschluß des Selbsttests übermittelt die Selbsttesteinrichtung B ein Ergebnissignal S nach außerhalb der integrierten Schaltung IC. Das Ergebnissignal S gibt Auskunft über das Ergebnis aller zuvor durchgeführten Tests.

Figur 1 ist weiterhin ein externer Programmspeicher ME zu entnehmen, der zum Speichern mehrerer Testprogramme P dient. Die Selbsttesteinrichtung B der integrierten Schaltung IC weist einen Steuerausgang CTR auf, der mit einem Steuereingang des externen Programmspeichers ME verbunden ist. Weiterhin ist ein Datenausgang des externen Programmspeichers ME mit einem Dateneingang des internen Programmspeichers MI der integrierten Schaltung IC verbunden. Die Selbsttesteinrichtung B übermittelt über ihren Steuerausgang CTR Steuersignale an den externen Programmspeicher ME, in deren Abhängigkeit dieser das jeweils gewünschte Testprogramm P an den internen Programmspeicher MI übermittelt. Somit ist die Selbsttesteinrichtung B in der Lage, selbsttätig den Zeitpunkt zu bestimmen, zu dem ein jeweils auszuführendes Testprogramm P in den internen Programmspeicher MI geladen werden soll. Die Selbsttesteinrichtung B der integrierten Schaltung IC hat gegenüber dem externen Programmspeicher ME also eine Master-Funktion. Das Laden eines Testprogrammes kann beispielsweise immer bei einer Initialisierung der integrierten Schaltung IC während ihrer Inbetriebnahme erfolgen. Dann enthält die Selbsttesteinrichtung B eine Schaltungsgruppe zur Erkennung eines entsprechenden Initialisierungssignals.

Im vorliegenden Fall testet die Selbsttesteinrichtung B die Schaltungseinheit C mittels einer großen Anzahl von nacheinander durchzuführender Testprogramme P. Zu diesem Zweck steuert die Selbsttesteinrichtung B über ihren Steuerausgang CTR selbsttätig das Laden des jeweils nachfolgenden Testprogrammes P in den internen Programmspeicher MI nach Beendigung des jeweils zuvor auszuführenden Testprogrammes P. Auf die beschriebene Weise erfolgt das Abarbeiten mehrerer Testprogramme P in zeitoptimierter Weise, ohne daß zwischen der Ausführung der unterschiedlichen Testprogramme unnötige Wartezeiten entstehen.

Vorteilhafterweise benötigt die in Figur 1 dargestellte integrierte Schaltung IC keine zusätzliche externe Schaltungseinheit zur Steuerung des Ladens der Testprogramme P aus dem externen Programmspeicher ME in den internen Programmspeicher MI. Somit kann der Selbsttest durch die Selbsttesteinrichtung B mit geringem Hardwareaufwand durchgeführt werden.

Besondere Vorteile ergeben sich, wenn eine große Anzahl von integrierten Schaltungen, die wie in Figur 1 dargestellt aufgebaut sind, gleichzeitig einen Selbsttest durchführen. Wenn beispielsweise jeder der integrierten Schaltungen ein separater externen Programmspeicher ME zugeordnet wird, in dem jeweils dieselben Testprogramme P gespeichert sind und mit dem die jeweilige Selbsttesteinrichtung B über ihren Steuerausgang CTR verbunden ist, ist die Abarbeitung der aufeinanderfolgenden Testprogramme P durch die unterschiedlichen integrierten Schaltungen IC zeitlich voneinander entkoppelt. Dies ist ein weiterer Vorteil gegenüber der Steuerung der Zuführung der Testprogramme P durch eine externe Steuereinheit.

Figur 2 zeigt einen Ausschnitt einer zu Figur 1 alternativen Ausführungsform der Erfindung, die sich nur bezüglich der in Figur 2 dargestellten Komponenten von dieser unterscheidet. Der Steuerausgang CTR der Selbsttesteinrichtung B in Figur 2 ist mit dem Steuereingang eines Adreßzählers AC verbunden, der in Abhängigkeit des Steuersignals eine oder mehrere Adressen ADR an den externen Programmspeicher ME übermittelt. Der externe Programmspeicher ME übermittelt über seinen Datenausgang das jeweils durch die erhaltenen Adressen ADR bestimmte Testprogramm P an den internen Programmspeicher MI.

Die Abarbeitung der Testprogramme P durch die Selbsttesteinrichtung B erfolgt gemäß eines Arbeitstaktes, der entweder auf der integrierten Schaltung IC selbst generiert wird oder dieser über einen speziellen Takteingang von außerhalb zugeführt wird.

Das Ergebnissignal S der Selbsttesteinrichtung B wird bei den vorliegenden Ausführungsbeispielen jeweils nach der Ausführung aller Testprogramme P nach außerhalb der integrierten Schaltung IC übermittelt. Im einfachsten Fall handelt es sich dabei um ein Ergebnissignal, das nur Auskunft darüber gibt, ob die integrierte Schaltung IC beziehungsweise die darin getestete Schaltungseinheit C einen Fehler aufweist oder nicht (Fail/No-Fail-Signal).

Es kann vorgesehen sein, den Selbsttest durch die Selbsttesteinrichtung B nur in einer Testbetriebsart der integrierten Schaltung IC durchzuführen, wobei letztere auf bekannte Weise in die Testbetriebsart versetzbar ist. Bekannte sogenannte Test-Mode-Entries sind beispielsweise in verschiedenen JEDEC-Normen beschrieben.

## Patentansprüche

1. Integrierte Schaltung (IC)
- mit einer Selbsttesteinrichtung (B) zur Durchführung eines Selbsttests der integrierten Schaltung, die einen Steuerausgang (CTR) aufweist,
- und mit einem mit der Selbsttesteinrichtung verbundenen Programmspeicher (MI) zum Speichern wenigstens eines von außerhalb der integrierten Schaltung zugeführten Testprogrammes (P), das während der Durchführung eines Selbsttests durch die Selbsttesteinrichtung ausgeführt wird,
- wobei die Selbsttesteinrichtung (B) das Laden des jeweils auszuführenden Testprogrammes von außerhalb der integrierten Schaltung in den Programmspeicher über ihren Steuerausgang (CTR) steuert.

2. Integrierte Schaltung nach Anspruch 1,
deren Selbsttesteinrichtung (B) mehrere Testprogramme (P) nacheinander ausführt und durch Steuerung über ihren Steuerausgang (CTR) das jeweils nächste Testprogramm nach Beendigung des vorhergehenden Testprogrammes selbsttätig von außerhalb der integrierten Schaltung in den Programmspeicher (MI) lädt.

3. Integrierte Schaltung nach Anspruch 2,
deren Selbsttesteinrichtung (B) einen Ausgang für ein Ergebnissignal (S) aufweist, an dem sie nach Ausführung mehrerer nacheinander von außerhalb der integrierten Schaltung in den Programmspeicher (MI) geladener Testprogramme (P) ein gemeinsames Ergebnissignal (S) für die gemäß der ausgeführten Testprogramme durchgeführten Tests nach außerhalb der integrierten Schaltung (IC) liefert.

## Claims

1. Integrated circuit (IC)
- having a self-test device (B) for carrying out a self-test of the integrated circuit which has a control output (CTR),
- and having a program memory (MI), connected to the self-test device, for storing at least one test program (P) which is supplied from outside the integrated circuit and which is executed while a self-test is being carried out by the self-test device,
- the self-test device (B) controlling the loading of the respective test program which is to be executed, from outside the integrated circuit into the program memory via its control output (CTR).

2. Integrated circuit according to Claim 1,
the self-test device (B) of which executes a plurality of test programs (P) in succession, and, after completion of the preceding test program, automatically loads the respectively next test program into the program memory (MI) from outside the integrated circuit by controlling via its control output (CTR).

3. Integrated circuit according to Claim 2,
the self-test device (B) of which has an output for a result signal (S) at which a common result signal (S) for the tests which have been carried out in accordance with the executed test programs is supplied outside the integrated circuit (IC) after the execution of a plurality of test programs (P) which have been loaded in succession into the program memory (MI) from outside the integrated circuit.

## Revendications

1. Circuit (IC) intégré
- comprenant un dispositif (B) d'autovérification pour effectuer une autovérification du circuit intégré, qui comporte une sortie (CTR) de commande,
- et comprenant une mémoire (MI) de programme reliée au dispositif d'autovérification pour mémoriser au moins l'un des programmes (P) de vérification envoyé de l'extérieur au circuit intégré et réalisé par le dispositif d'autovérification pendant que s'effectue une autovérification,
- le dispositif (B) d'autovérification commandant le chargement du programme de vérification respectif à effectuer de l'extérieur du circuit intégré à la mémoire de programme par sa sortie (CTR) de commande.

2. Circuit intégré suivant la revendication 1, dont le dispositif (B) d'autovérification réalise plusieurs programmes (P) de vérification les uns après les autres et, par commande par sa sortie (CTR) de commande, charge le programme de vérification suivant respectif après achèvement du programme de vérification précédent automatiquement de l'extérieur du circuit intégré dans la mémoire (MI) du programme.

3. Circuit intégré suivant la revendication 2, dont le dispositif (B) d'autovérification comporte une sortie pour un signal (S) de résultat à laquelle il fournit, après réalisation de plusieurs programmes (P) de vérification chargés l'un après l'autre de l'extérieur du circuit intégré dans la mémoire (MI) de programme, un signal (S) commun de résultat pour les vérifications effectuées suivant les programmes de vérification réalisés et allant à l'extérieur du circuit (IC) intégré.
